# EUROPEAN PATENT SPECIFICATION

(11) **EP 0 358 567 B1**
(45) Date of publication and mention of the grant of the patent: **27.03.1996**
(21) Application number: 89402419.9
(22) Date of filing: 05.09.1989
(51) Int. Cl.: G03F 1/16, G03F 7/20

(54) **Method of exposing patterns of semiconductor devices and stencil mask for carrying out same**
Belichtungsverfahren für Halbleiteranordnungen und Lochmaske dafür
Procédé pour l'exposition de motifs de dispositifs semi-conducteurs et masque stencil à cet effet

(30) Priority: 06.09.1988 JP 222981/88
(43) Date of publication of application: 14.03.1990
(73) Proprietor: FUJITSU LIMITED, Kawasaki-shi, Kanagawa 211 (JP)
(72) Inventor: Oae, Yoshihisa, Kawasaki-shi Kanagawa 213 (JP); Sakamoto, Kiichi, Tokyo 170 (JP)
(74) Representative: Joly, Jean-Jacques

(56) References cited:
- US-A- 4 181 860
- PATENT ABSTRACTS OF JAPAN vol. 12, no. 224 (P-721)(3071) 25 June 1988, & JP-A- 63 018352

## Description

### BACKGROUND OF THE INVENTION

### 1. Field of the Invention

The present invention relates to a method and a stencil mask for exposing patterns of semiconductor devices, more specifically, it relates to a pattern exposing method in which a design pattern of a device is divided into a plurality of unit patterns, which are then transferred onto a semiconductor substrate in an adjoining arrangement to be connected and complete an integral device pattern.

### 2. Description of the Related Art

Recent ultra-fine patterns such as in a 16M DRAM (dynamic random access memory) have a fine line width and a fine line interval. The line width or interval (frequently referred to as "design rule") decreases as the memory capacity increases, for example, from 1 µm for 1M DRAM to 0.7 µm for 4M, 0.5 µm for 16M, 0.2 µm for 64M, and so on.

Since most of such an ultra-fine device pattern is generally composed of a plurality of repeat patterns, a stencil transfer exposure method is proposed, in which the portion of repeat patterns is divided into a plurality of corresponding unit patterns, transmitting openings having a shape defining a charged particle beam conforming to the respective unit patterns are disposed in a stencil mask, which is then placed in an optical arrangement, a transmitting opening is selected in accordance with the unit patterns to be exposed, the charged particle beam is irradiated through the selected opening to expose the selected unit pattern at the predetermined sites on a substrate, and irradiation or exposure of other unit patterns is repeated for other predetermined sites on the substrate in an adjoining relationship with each other to be connected with each other on the substrate and thereby complete the pattern of the portion of repeat patterns, the other portion of non-repeat patterns being exposed by using a variable rectangular beam.

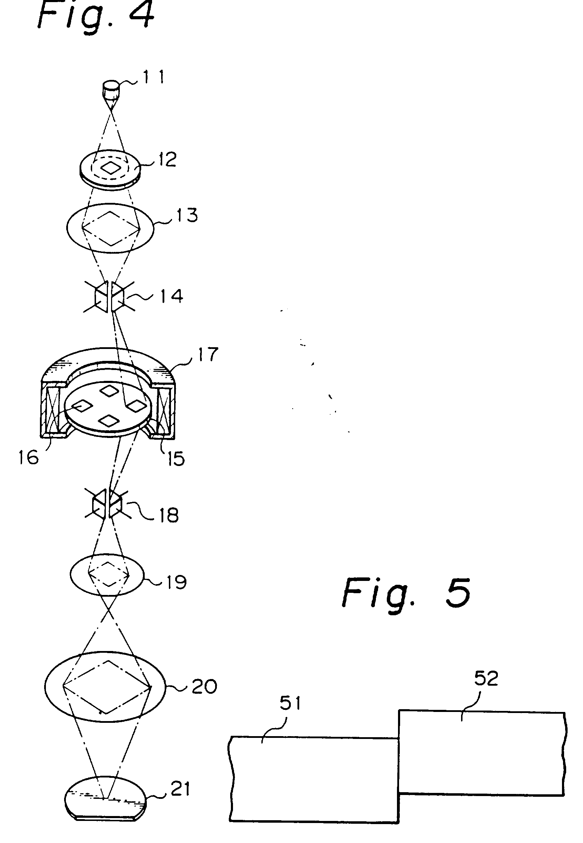

In the stencil transfer exposure method, when unit patterns are exposed in an adjoining arrangement, a location error or displacement occurs at the connecting region of two adjoining unit patterns to significant extent due to the limited accuracy of positioning. Such a location error causes a problem in recent ultra-fine device patterns. For example, a transversal displacement between adjoining unit patterns as shown in Fig. 5 causes an excessively small width of pattern lines 51 and 52 at the connecting region as shown in Fig. 5, which will result in a connection failure, disconnection, or other defects. It is therefore necessary to take measures to prevent location errors while exposing unit patterns in an adjoining arrangement.

A method is proposed in Japanese Unexamined Patent Publication (Kokai) No. 62-206829, in which exposure is carried out such that the ends of pattern lines of two adjoining unit patterns are partially overlapped as shown in Fig. 4(a) of the publication.

This method, however, inevitably leads to an excessive broadening of the exposed pattern lines at the connecting region, since the connecting ends are exposed twice. This will cause a problem, particularly for recent ultra-fine patterns, in that an undesired connection could occur between two adjacent lines which must not be connected.

Patent Abstracts of Japan, volume 12, No 224 (P-271)(3071) of June 25, 1989, and JP-A-63 018352 also disclose a wiring pattern in which pattern lines at the boundary area of adjacent masks are enlarged. To enable this enlargement of the pattern lines, the wiring pitch at the boundary mask must be increased.

According to the present invention, there is provided a method of exposing a semiconductor device pattern onto a semiconductor substrate by repeatedly exposing in an adjoining arrangement a plurality of unit patterns obtained by dividing at least part of a device pattern, thereby connecting the unit patterns to complete said part of the device pattern on the substrate, the unit patterns comprising pattern lines wherein pattern lines of adjacent unit patterns are to be connected together at connection ends of the pattern lines, which method comprises : dividing at least part of a device pattern into a plurality of unit patterns; preparing a stencil mask provided with transmitting openings having shapes conforming to the respective unit patterns; placing the stencil mask in an optical arrangement for projecting the unit patterns onto the substrate; irradiating a beam of charged particles or light through one of the openings for exposing one corresponding unit pattern onto the predetermined sites of the substrate; and repeating said irradiation through other openings for exposing the respective corresponding unit patterns onto the respective predetermined sites of the substrate until said part of the device pattern is completely transferred onto the substrate, in which the preparation of the openings in stencil mask is such that the irradiating steps for exposing the unit patterns define at least one protrusion on at least one of adjacent connection ends of pattern lines of the adjacent unit patterns, the protrusion having a width less than that of the corresponding pattern lines.

The present invention also provides a stencil mask. JP-A-63 018352 discloses a stencil mask used for exposing patterns of semiconductor substrate by repeatedly exposing in an adjoining arrangement a plurality of unit patterns obtained by dividing at least part of a device pattern, thereby connecting the unit patterns to complete said part of the device pattern on the substrate, the unit patterns comprising pattern lines wherein pattern lines of adjacent unit patterns are to be connected together at connection ends of the pattern lines, which mask comprises : a plate body having a plurality of openings disposed therein for transmitting a beam of charged particles or light therethrough, said openings having shapes conforming to the respective unit patterns.

For the stencil mask according to the invention, the openings of the stencil mask for adjacent unit patterns comprise at least one protrusion on at least one of adjacent connection ends of pattern lines of the adjacent unit patterns, the protrusion having a width less than that of the corresponding pattern lines.

The method and stencil mask according to the invention enables reliable connection between pattern lines of adjoining unit patterns, while avoiding excessive broadening of the exposed pattern lines at the connection region.

To more easily effect a connection between pattern line ends under a given positioning accuracy, preferably one of a pair of pattern lines to be connected has a smooth connecting end and the other has a connecting end provided with at least one protrusion.

From the view point of manufacturing an ultra-fine pattern such that pattern lines have a width or a interval less than 1 µm, one protrusion should be provided on at least one of the pair of connecting ends.

In the present invention, the pattern line ends are partially exposed twice upon exposing the adjoining unit patterns. The protrusion provided at at least one of the connecting ends decreases the amount of irradiation beam energy introduced in the duplicately exposed region, in comparison with that introduced when both connecting ends are smooth. This enables an excessive broadening of the exposed lines at the connecting region to be avoided while ensuring a reliable connection between lines.

### BRIEF DESCRIPTION OF THE DRAWINGS

Figure 1 shows an exposure of a device pattern using unit patterns having one protrusion at one connecting end of a pattern line, the other end being smooth, according to the present invention;
Fig. 2 shows other embodiments of the protrusion according to the present invention;
Fig. 3 shows another embodiment of exposing a device pattern according to the present invention, in which both connecting ends have a protrusion;
Fig. 4 shows a constitution of an electron beam exposure apparatus;
Fig. 5 shows transversal displacement in the conventional method;
Fig. 6 shows the exposed ends of pattern lines to be connected under a longitudinal displacement condition for smooth connecting ends of the conventional method (a) and (b) and protruded connecting ends according to the present invention (c);
Fig. 7 shows the exposed ends of pattern lines to be connected under a transversal displacement condition for smooth connecting ends of the conventional method (a) and (b) and protruded connecting ends according to the present invention (c); and
Fig. 8 shows an embodiment of the details of the stencil mask 15 of Fig. 4 in the upside-down position.

### DESCRIPTION OF THE PREFERRED EMBODIMENT

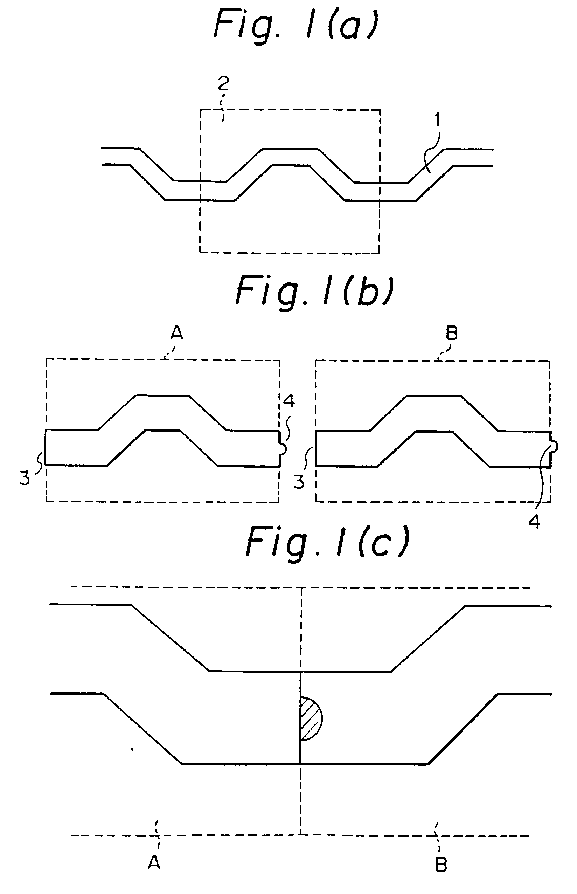

Figure 1 shows an exposure of a device pattern using unit patterns having one protrusion at one connecting end of a pattern line, the other end being smooth, according to the present invention.

A design pattern 1 composed of repeat patterns 2 as shown in Fig. 1(a) is divided into a unit pattern conforming to the repeat pattern 2 as shown in Fig. 1(b) as two adjoining exposures A and B. A semicircular protrusion 4 having a diameter of half the width of the pattern line 1 is provided at one connecting end of the line 1. The other end 3 is smooth. When both ends 3 and 4 connected at the connecting region of two exposures A and B without displacement, only the hatched region 5 of Fig. 1(c) is exposed twice and no excessive broadening of the exposed lines occurs at the connecting region.

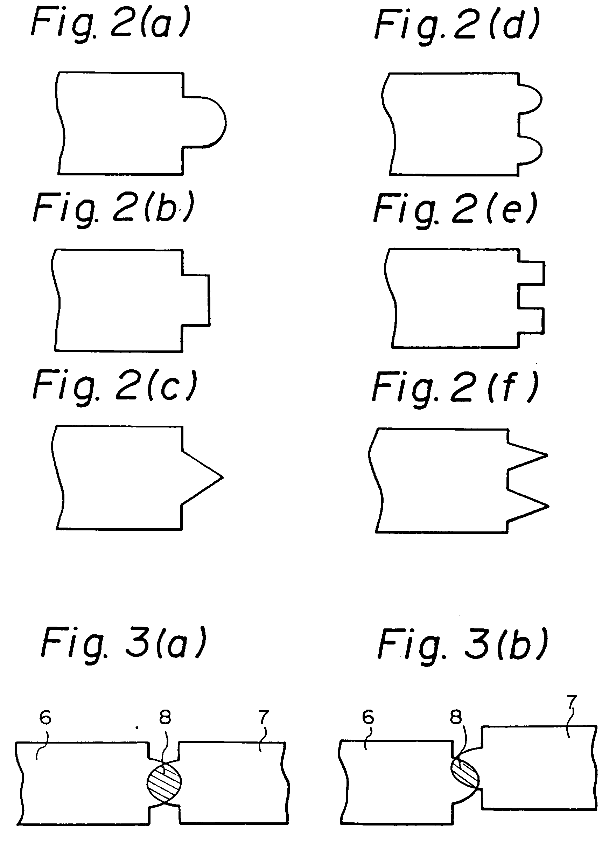

The protrusion may have any shape in addition to a semicircle, as shown in Fig. 2(a) to (f).

Figure 3 shows another embodiment of exposing a device pattern according to the present invention, in which both connecting ends have a protrusion.

Pattern lines 6 and 7 of two adjoining unit patterns have a semicircular protrusion at both ends thereof and the unit patterns are exposed such that the protrusions are overlapped with each other. Figure 3(a) shows the exposed pattern without displacement, and Fig. 3(b) shows one with a slight displacement. For both cases, the hatched region 8 is exposed twice to cause a broadening of the exposed pattern lines but the broadened line width cannot significantly exceed the designed line width, since the duplicately exposed region 8 has a width of one half of the line width or less.

The above embodiment will be described in more detail in comparison with the conventional method using a smooth connecting end.

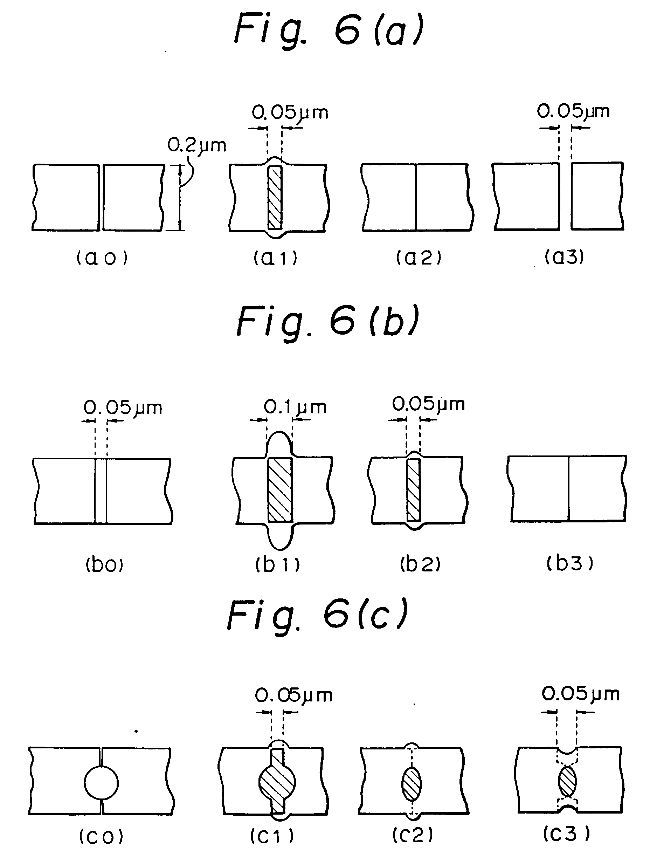

Referring to Fig. 6, the exposed ends of pattern lines to be connected under a longitudinal displacement condition will be discussed. Figures 6(a) to (c) show the connection regions of the exposed patterns for the conventional method (a) and (b) and the above embodiment of the present invention (c). The line width is 0.2 µm and the maximum displacement due to positioning accuracy is 0.05 µm for all cases (a) to (c).

Figure 6(a) shows a case in which exposure is carried out under a preset positioning such that no overlapping occurs, i.e., the mating ends are just in contact with each other. When overlapping occurs due to an uncontrollable displacement, the connecting region is exposed twice over the entire width of pattern line and causes an excessive broadening of the exposed lines (a1). When no displacement occurs, a connection is established at the designed width (a2). When an uncontrollable displacement occurs in the separating direction, the line ends cannot be connected with each other, resulting in a disconnection of the device pattern (a3).

Figure. 6(b) shows a case in which exposure is carried out under a preset positioning such that overlapping occurs to an extent of 0.05 µm (b0). Overlapping due to an uncontrollable displacement (b1) will cause an excessive and more extensive broadening of the exposed lines than in the case (a). Even when no displacement occurs, the preset overlapping of 0.05 µm will occur, which results in an excessive broadening of the exposed line to the same extent as in the case (a1). When an uncontrollable displacement occurs in the separating direction, a connection is established at the designed width (b2).

Figure 6(c) shows a case according to the present invention. Neither an excessive broadening of the exposed lines as in the case (b) due to an uncontrollable displacement in the overlapping direction, nor a disconnection as in the case (a) due to an uncontrollable displacement in the separating direction, occurs, and therefore, the present invention enables a highly reliable connection between pattern lines.

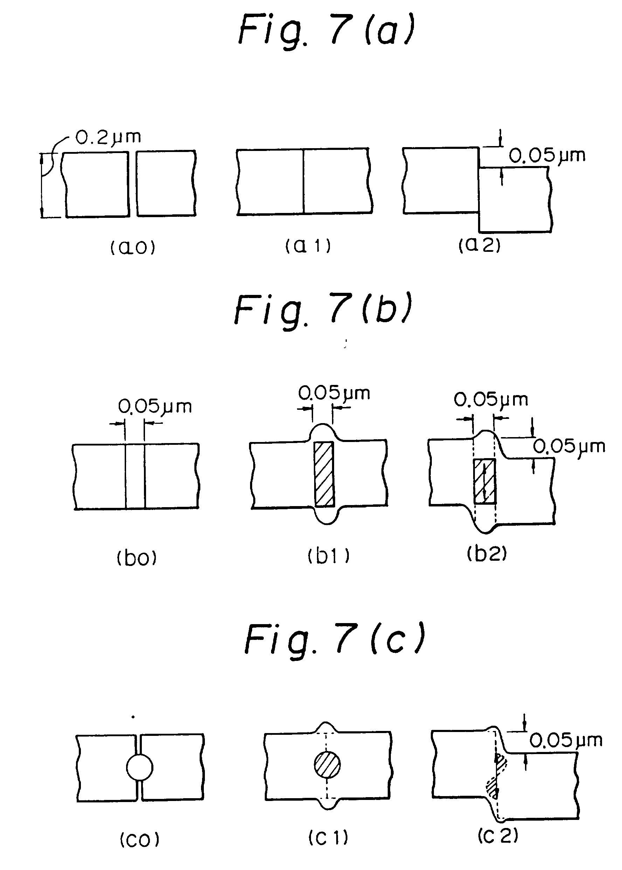

Referring to Fig. 7, the exposed ends of pattern lines to be connected under a transversal displacement condition will be discussed. The cases (a) to (c) of Fig. 7 are under similar conditions as for the cases (a) to (c) of Fig. 6, respectively, except for the displacement direction.

Figure 7(a) shows that a transversal displacement of 0.05 µm reduces the pattern line width from the design rule of 0.2 µm to an excessively small width of 0.1 µm.

Figure 7(b) shows that a transversal displacement reduces the area of duplicate exposure as shown by cross hatching (a2) in comparison with the area duplicately exposed with no displacement (a1), and the broadening of the exposed lines is also reduced but is still present. The duplicate exposure area, and, in turn, the degree of broadening, varies with the amount of displacement, i.e., the greater the displacement, the smaller the broadening and vice versa. Naturally, a greater displacement should result in a greater reduction of the line width, but the above relationship is contrary to this normally expected condition and provides an adverse effect in that both the broadening and the reduction of line width are undesirably accelerated.

Figure 7(c) shows that an optimized shape of the protrusion can keep the duplicately exposed area unchanged under a given amount of displacement, as seen from the comparison between (c1) and (c2), which prevents the undesired variation of the area such as in (b). A displacement within the region in which the duplicate exposure region is present may cause broadening, but the degree of the broadening is reduced, since the distance from the line end is increased although the total area of duplicate exposure is unchanged. Additionally, for the region in which a reduction of line width will occur (shown with a double-headed arrow), a transverse displacement makes the duplicate exposure region closer to the line end and results in a greater broadening effect. This effect is also obtained in the case (b). Thus, the case (c) according to the present invention effectively prevents both the reduction of the line width as in the case (a) and the broadening as in the case (b).

As described above, the present invention effectively prevents an excessive broadening of the exposed pattern lines at the connecting region, in comparison with the conventional method, under a given degree of displacement, i.e., a given positioning accuracy.

An embodiment of pattern forming by using the method according to the present invention will be described, referring to Fig. 4 showing an assembly of an electron beam exposure apparatus.

An electron gun 11 disposed at the upper portion of the body tube evacuated to a high vacuum level irradiates an electron beam to a rectangular shaping aperture 12. The beam, which has been shaped rectangularly upon passing through the aperture 12, is converged by a lens 13 and reaches a deflection plate 14 for selecting a basic cell.

The thus deflected beam is irradiated to one of the basic cells 16 disposed on a stencil mask 15. The basic cells 16 have a transmitting opening for defining the irradiated beam in the shape conforming to a unit pattern having a pattern line provided with at least one protrusion having a width less than that of the corresponding pattern line at at least one connecting end thereof. The beam is shaped to the shape of the unit pattern upon passing through the selected transmitting opening while converged and deflected back to be aligned with the electron gun axis by a condenser lens 17 disposed around the stencil mask 15, and then enters the region surrounded by correction deflection plates 18.

After correction of the irradiation direction by the correction deflection plates 18, a beam having the shape of the unit pattern is projected through a first and a second reducing lenses 19 and 20 onto a wafer 21 coated with a photosensitive agent, which exposes and images the unit pattern on the wafer 21.

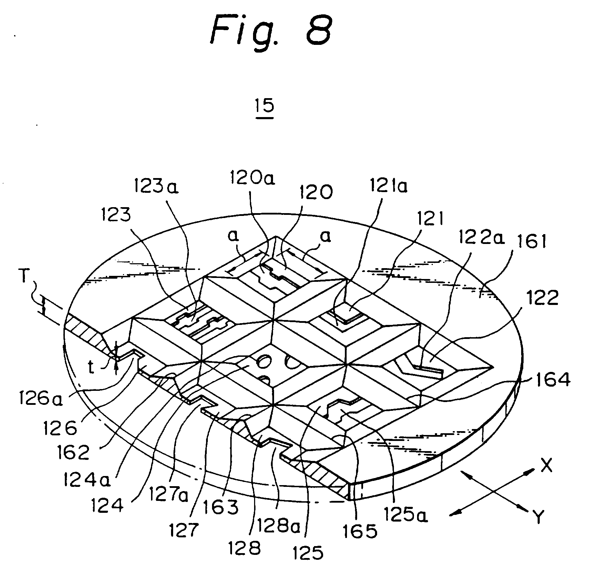

Referring to Fig. 8, a preferred embodiment of he stencil mask 15 is described in detail. The stencil mask 15 made of a silicon substrate having a thickness T of 400 to 500 µm has pattern regions 120 to 128 in which transmitting openings 120a to 128a having the shapes of the respective unit patterns are formed. Each of the pattern regions 120 to 128 is in the form of a square with an edge length of 500 µm and having a thickness of about 10 µm. Crosspieces 162 and 163 extending in the X-direction and crosspieces 164 and 165 extending in the Y-direction compose a lattice. The sections of the crosspieces 162 to 165 have the form of a triangle having a height H slightly lower than the thickness T. These crosspieces have a high mechanical strength and effectively serve as a heat path. The stencil mask 15 thus has a constitution such that the pattern regions 120 to 128 are surrounded by the crosspieces 162 to 165, respectively, to have a greater thickness at the periphery thereof.

The above constitution of the stencil mask 15 brings an advantage in that the pattern regions 120 to 128 are reinforced over the whole periphery thereof to prevent pattern failure by impact loading during handling. The crosspieces also prevent thermal damage of the pattern regions. For example, an electron beam is irradiated to the pattern region denoted by the numeral 124 for exposing a circular pattern. Heat generated in the pattern region 124 is transferred to the surrounding crosspieces 162 to 165 and then conducted through the crosspieces 162 to 165 toward the crosspiece 161 while released from the surface of the crosspieces 162 to 165. Therefore, little heat is accumulated in the pattern region 124 and there is no risk of heat-induced deformation or fusion of the pattern region 124. This prevents deformation or failure of the transmitting opening 124a, and the unit pattern defined by the opening 124a can be exposed at a high accuracy. The same effect is obtained for other pattern regions.

Thus, the above-described embodiment of the stencil mask applicable to carrying out the present inventive method has an improved mechanical strength and an excellent thermal resistance.

Although the above embodiment of the stencil mask 15 has crosspieces both in the directions X and Y, crosspieces may be provided either in the X or Y direction, which can bring an effect of improving the mechanical strength and the thermal resistance. The provision of crosspieces in one direction also has an advantage in that more pattern regions can be contained in the same area of a stencil mask in accordance with the space otherwise required for crosspieces.

By selecting one of the unit patterns and exposing in an adjoining arrangement the selected unit patterns in the manner as described above, a design pattern of semiconductor device can be transferred onto the wafer so that the pattern lines to be connected are reliably connected without excessive broadening of the exposed pattern lines at the connecting region between adjoining unit patterns.

As described above, the present invention uses a protrusion provided at the connecting end of pattern lines to prevent not only the excessive broadening of the exposed lines at the connecting region but also the disconnecting of device a pattern even under the condition of a possible displacement upon each of the unit pattern exposures.

Although the protrusion at the connecting ends can be adopted in the conventional method using a point beam or a variable beam, the resulting increase of the process control parameters will reduce the process throughput. In the present inventive method, in which the unit patterns selected from a stencil are transferred, the provision of a protrusion in the unit patterns of a stencil causes no increase of the process control parameters, and accordingly, no reduction of the throughput.

## Claims

1. A method of exposing a semiconductor device pattern onto a semiconductor substrate by repeatedly exposing in an adjoining arrangement a plurality of unit patterns obtained by dividing at least part of a device pattern, thereby connecting the unit patterns (2) to complete said part of the device pattern on the substrate, the unit patterns comprising pattern lines (1) wherein pattern lines of adjacent unit patterns are to be connected together at connection ends of the pattern lines (1), which method comprises :
dividing at least part of a device pattern into a plurality of unit patterns (2);
preparing a stencil mask (15) provided with transmitting openings having shapes conforming to the respective unit patterns (2);
placing the stencil mask (15) in an optical arrangement for projecting the unit patterns onto the substrate (21);
irradiating a beam of charged particles or light through one of the openings for exposing one corresponding unit pattern (2) onto the predetermined sites of the substrate (21); and
repeating said irradiation through other openings for exposing the respective corresponding unit patterns onto the respective predetermined sites of the substrate (21) until said part of the device pattern is completely transferred onto the substrate (21), characterized in that the preparation of the openings in the stencil mask is such that the irradiating steps for exposing the unit patterns define at least one protrusion (4) on at least one of adjacent connection ends (3, 3) of pattern lines (1) of the adjacent unit patterns (2), the protrusion (4) having a width less than that of the corresponding pattern lines (1).

2. A method according to claim 1, wherein one of a pair of pattern lines (1) to be connected has a smooth connecting end (3) and the other has a connecting end provided with at least one protrusion (4).

3. A method according to claim 1, wherein pattern lines (1) to be connected with each other bridging adjoining unit patterns (2) have at least one connecting end provided with one protrusion (4).

4. A method according to claim 1, 2, or 3, wherein said protrusion (4) is semicircular.

5. A stencil mask (15) used for exposing patterns of semiconductor substrate (21) by repeatedly exposing in an adjoining arrangement a plurality of unit patterns (2) obtained by dividing at least part of a device pattern, thereby connecting the unit patterns to complete said part of the device pattern on the substrate (2), the unit patterns comprising pattern lines (1) wherein pattern lines of adjacent unit patterns are to be connected together at connection ends (3, 3) of the pattern lines (1), which mask comprises :
a plate body having a plurality of openings disposed therein for transmitting a beam of charged particles or light therethrough, said openings having shapes conforming to the respective unit patterns (2),
characterized in that the openings of the stencil mask for adjacent unit patterns comprise at least one protrusion (4) on at least one of adjacent connection ends (3, 3) of pattern lines (1) of the adjacent unit patterns, the protrusion (4) having a width less than that of the corresponding pattern lines.

6. A stencil mask according to claim 5, wherein an opening conforming to one of a pair of pattern lines (1) to be connected has a smooth connecting end (3) and an opening conforming to the other has a connecting end provided with at least one protrusion (4).

7. A stencil mask according to claim 5, wherein the openings conforming to pattern lines to be connected with each other bridging adjoining unit patterns have at least one connecting end provided with one protrusion (4).

8. A stencil mask according to claim 5, 6, or 7, wherein said protrusion is semicircular.

## Patentansprüche

1. Verfahren zum Belichten eines Halbleiterelementmusters auf einem Halbleitersubstrat durch wiederholtes Belichten, in aneinander angrenzender Anordnung, einer Vielzahl von Einheitsmustern, die durch Aufteilen mindestens eines Teils eines Elementmusters erhalten sind, dadurch Miteinanderverbinden der Einheitsmuster (2) zur Vervollständigung des genannten Teils des Elementmusters auf dem Substrat, wobei die Einheitsmuster Musterlinien (1) aufweisen, wobei die Musterlinien von einander angrenzenden Einheitsmustern an den Anschlußenden der Musterlinien (2) miteinander zu verbinden sind, welches Verfahren umfaßt:
das Aufteilen mindestens eines Teils eines Elementmusters in eine Vielzahl von Einheitsmustern (2),
das Herstellen einer Schablonenmaske (15), die mit Durchtrittsöffnungen mit Formen entsprechend den jeweiligen Einheitsmustern (2) ausgestattet ist,
das Anordnen der Schablonenmaske (15)in einer optischen Einrichtung zum Projizieren der Einheitsmuster auf das Substrat (21),
das Einstrahlen eines Strahls von Ladungspartikeln oder von Licht durch eine der Öffnungen zum Belichten eines entsprechenden Einheitsmusters (2) auf den vorbestimmten Stellen des Substrats (21) und
das wiederholte Einstrahlen durch weitere Öffnungen zum Belichten der jeweiligen entsprechenden Einheitsmuster auf den jeweiligen vorbestimmten Stellen des Substrats (21), bis der genannte Teil des Elementmusters vollständig auf das Substrat (21) übertragen ist, dadurch gekennzeichnet, daß die Herstellung der Öffnungen in der Schablonenmaske eine derartige ist, daß die Einstrahlungsschritte zum Belichten der Einheitsmuster mindestens einen Vorsprung (4) an mindestens einem der aneinander angrenzenden Anschlußenden (3, 3) der Musterlinien (1) von aneinander angrenzenden Einheitsmustern (2) ausbilden, wobei der Vorsprung (4) eine Breite kleiner als diejenige der entsprechendem Musterlinien (1) aufweist.

2. Verfahren nach Anspruch 1, wobei eine Musterlinie eines Paars von miteinander zu verbindenden Musterlinien (1) ein glattes Anschlußende (3) und die andere Musterlinie ein Anschlußende aufweist, das mit mindestens einem Vorsprung (4) ausgestattet ist.

3. Verfahren nach Anspruch 1, wobei die miteinander zu verbindenden Musterlinien (1), die aneinander angrenzende Einheitsmuster miteinander überbrückend verbinden, mindestens ein Anschlußende aufweisen, das mit einem Vorsprung (4) ausgestattet ist

4. Verfahren nach Anspruch 1, 2 oder 3, wobei der Vorsprung (4) halbkreisförmig ist.

5. Schablonenmaske (15), die zum Belichten von Mustern eines Halbleitersubstrats (21) verwendet wird, indem wiederholt in einer aneinander angrenzenden Anordnung eine Vielzahl von Einheitsmustern (2) exponiert wird, die durch Aufteilen mindestens eines Teils eines Elementmusters erhalten werden, wobei die Einheitsmuster miteinander verbunden werden, um den genannten Teil des Elementmusters auf dem Substrat (21) zu vervollständigen, wobei die Einheitsmuster Musterlinien (1) aufweisen und die Musterlinien von aneinander angrenzenden Einheitsmustern an den Anschlußenden (3, 3) der Musterlinien miteinander zu verbinden sind, wobei die Maske umfaßt:
einen Plattenkörper mit einer Vielzahl von darin zum Durchtritt eines Strahls von Ladungsteilchen oder Licht angeordneten Öffnungen, wobei die Öffnungen Formen entsprechend den jeweiligen Einheitsmustern (2) besitzen,
dadurch gekennzeichnet, daß die Öffnungen der Schablonenmaske für aneinander angrenzende Einheitsmuster mindestens einen Vorsprung (4) an mindestens einem der aneinander angrenzenden Anschlußenden (3, 3) der Musterlinien (1) der aneinander angrenzenden Einheitsmuster aufweisen, wobei der Vorsprung (4) eine Breite kleiner als diejenige der entsprechenden Musterlinien aufweist.

6. Schablonenmaske nach Anspruch 5, bei der eine Öffnung, die konform zu einer Musterlinie eines Paars von miteinander zu verbindenden Musterlinien (1) ausgebildet ist, ein glattes Anschlußende (3) und eine Öffnung, die konform zu der anderen Musterlinie ausgebildet ist, ein Anschlußende aufweist, das mit mindestens einem Vorsprung (4) ausgestattet ist.

7. Schablonenmaske nach Anspruch 5, bei der die Öffnungen, die konform zu den miteinander zu verbindenden Musterlinien, die aneinander angrenzende Einheitsmuster überbrückend verbinden, ausgebildet sind, mindestens ein Anschlußende aufweisen, das mit einem Vorsprung (4) ausgestattet ist

8. Schablonenmaske nach Anspruch 5, 6 oder 7, bei der der Vorsprung (4) halbkreisförmig ist.

## Revendications

1. Procédé permettant d'exposer un motif de dispositif à semiconducteur sur un substrat semiconducteur en exposant de façon répétée, suivant un agencement jointif, une pluralité de motifs unitaires que l'on obtient par division d'au moins une partie d'un motif de dispositif, de sorte qu'on raccorde les motifs unitaires (2) pour achever la réalisation de ladite partie du motif de dispositif sur le substrat, les motifs unitaires comprenant des lignes (1) de motif, où les lignes de motif (1) de motifs unitaires adjacents doivent être raccordées ensemble aux extrémités de raccordement des lignes de motif (1), le procédé comprenant les opérations suivantes :
diviser au moins une partie d'un motif de dispositif en une pluralité de motifs unitaires (2) ;
préparer un masque du type stencil (15) doté d'ouvertures de transmission ayant des formes qui épousent celles des motifs unitaires respectifs (2);
placer le masque de type stencil (15) dans un montage optique afin de projeter les motifs unitaires sur le substrat (21);
irradier à l'aide d'un faisceau de particules chargées ou de lumière, via l'une des ouvertures servant à exposer un motif unitaire correspondant (2), les sites prédéterminés du substrat (21); et
répéter ladite irradiation, via d'autres ouvertures servant à exposer les motifs unitaires correspondants respectifs, des sites prédéterminés respectifs du substrat (21) jusqu'à ce que ladite partie du motif de dispositif ait été complètement transférée sur le substrat (21);
caractérisé en ce que la préparation des ouvertures ménagées dans le masque de type stencil est telle que les opérations d'irradiation visant à exposer les motifs unitaires définissent au moins une partie saillante (4) sur au moins une des extrémités de raccordement adjacentes (3, 3) de lignes de motif (1) des motifs unitaires adjacents (2), la partie saillante (4) ayant une largeur inférieure à celle des lignes de motif correspondantes (1).

2. Procédé selon la revendication 1, où une ligne d'une paire de lignes de motif (1) à raccorder possède une extrémité de raccordement (3) lisse et l'autre des lignes possède une extrémité de raccordement dotée d'au moins une partie saillante (4).

3. Procédé selon la revendication 1, où les lignes de motif (1) à raccorder l'une avec l'autre pour mettre en liaison des motifs unitaires adjacents (2) ont au moins une extrémité de raccordement qui est dotée d'une partie saillante (4).

4. Procédé selon la revendication 1, 2 ou 3, où ladite partie saillante (4) est semi-circulaire.

5. Masque du type stencil (15) utilisé pour exposer des motifs de substrat semiconducteur (21) par exposition répétée, suivant un agencement jointif, d'une pluralité de motifs unitaires (2) que l'on obtient en divisant au moins une partie d'un motif de dispositif, de manière à raccorder les motifs unitaires pour achever la réalisation de ladite partie du motif de dispositif sur le substrat (2), les motifs unitaires comprenant des lignes de motif (1), où les lignes de motif (1) de motifs unitaires adjacents doivent être raccordées ensemble au niveau d'extrémités de raccordement (3, 3) des lignes de motif (1), le masque comprenant :
un corps de plaque possédant une pluralité d'ouvertures qui y sont disposées pour transmettre un faisceau de particules chargées ou de lumière, lesdites ouvertures ayant des formes qui épousent celles des motifs unitaires respectifs (2),
caractérisé en ce que les ouvertures du masque de type stencil relatives à des motifs unitaires adjacents comprennent au moins une partie saillante (4) sur au moins une des extrémités de raccordement adjacentes (3, 3) de lignes de motif (1) des motifs unitaires adjacents, la partie saillante (4) ayant une largeur inférieure à celle des lignes de motif correspondantes.

6. Masque du type stencil selon la revendication 5, où une ouverture dont la forme épouse celle d'une ligne d'une paire de lignes de motif (1) à raccorder possède une extrémité de raccordement (3) lisse et une ouverture dont la forme épouse celle de l'autre des lignes possède une extrémité de raccordement qui est dotée d'au moins une partie saillante (4).

7. Masque du type stencil selon la revendication 5, où les ouvertures dont les formes épousent celles de lignes de motif à raccorder l'une à l'autre pour mettre en liaison des motifs unitaires adjacents possèdent au moins une extrémité de raccordement dotée d'une partie saillante (4).

8. Masque du type stencil selon la revendication 5, 6 ou 7, où ladite partie saillante est semi-circulaire.
